# EUROPEAN PATENT APPLICATION

(11) **EP 4 635 935 A1**
(43) Date of publication of application: **22.10.2025**
(21) Application number: 25167807.4
(22) Date of filing: 01.04.2025
(51) Int. Cl.: C04B 41/45, C04B 41/50, C04B 41/52, C04B 41/89, C23C 16/40, C23C 16/455, C23C 28/04, C23C 28/00, F01D 5/28

(54) **ENVIRONMENTAL BARRIER COATINGS**

(30) Priority: 05.04.2024 US 202418628243
(71) Applicant: RTX Corporation, Farmington, CT 06032 (US)
(72) Inventor: JACKSON III, Richard Wesley, Mystic, 06355 (US); ZHU, Tianli, Glastonbury, 06033 (US); TANG, Xia, West Hartford, 06107 (US); BEALS, James, West Hartford, 06107 (US)
(74) Representative: Dehns

(57) **Abstract**

Environmental barrier coatings (EBCs) are disclosed having one or more sealing layers (40) incorporated therein to inhibit ingress of corrosive materials into EBCs and their associated ceramic materials (CMCs). The sealing layers (40) are yttrium oxide (Y₂O₃), lanthanum oxide (La₂O₃), ytterbium oxide (Yb₂O₃), hafnium oxide (HfO₂), zirconium oxide (ZrO₂), hafnium silicon oxide (HfSiO₄), zirconium silicon oxide (ZrSiO₄), ytterbium silicon oxide (Yb₂Si₂O₇), and/or aluminum oxide (Al₂O₃) layers, and are applied by atomic layer deposition.

## Description

### Field of the Invention

The present disclosure relates generally to environmental barrier coatings (EBCs) used for protection of ceramic matrix materials (CMCs) and methods of making same.

### Background

Ceramic matrix materials (CMCs) are often used in applications exhibiting high heat environments, for example, high-temperature components of gas turbine engines and heat shield systems used in space vehicles for re-entry. While these materials are able to withstand high temperatures, they are subject to deterioration over time due to the impact of corrosive forces. For example, CMCs containing Si are subject to Si volatilization in the presence of high temperature water vapor. The resultant loss of Si leads to formation of cracks and degradation of the CMC, eventually leading to failure of the components formed thereof.

To provide protection for CMC s from harsh environments and corrosive forces associated therewith, environmental barrier coating systems (EBCs) are used. For example, EBCs reduce exposure of the surface and interior (via penetration through pores and cracks) of CMCs to high temperature water vapor, thereby reducing degradation of CMCs and extending the operational lifespan of components made therefrom.

EBCs are typically multilayered structures. For example, an EBC can be a two layered system made up of an initial bond coat applied to the surface of the CMC substrate and a top coat. Other EBC systems can have more layers, for example, a multilayered bond coat and a top coat layer, or a bond coat layer, an inner top coat layer, and an outer top coat layer.

EBCs can themselves be susceptible to high temperature steam penetration which can lead to eventual failure of the EBC system. For example, layers of an EBC can exhibit pores and/or cracks that allow high temperature water vapor to penetrate into their interiors inducing degradation of the EBC system and possibly permitting high temperature steam to reach the CMC substrate.

The need exists to provide new EBC systems that exhibit improved abilities to inhibit degradation and increase the operational lifespan of components made from CMCs, as well as new methods for making EBC systems with such improved abilities.

### Summary of the Invention

In general, the present disclosure relates to using atomic layer deposition (ALD) to provide relatively thin sealing layers on one or more layers of an EBC system, or between a substrate and an EBC system, in order to seal pores and/or cracks and/or promote adhesion. Also, the present disclosure relates to improvements in inhibiting the ingress of corrosive materials into EBCs and their associated CMCs using sealing layers applied by atomic layer deposition.

According to one aspect of the present disclosure, there is provided a method for preparing an EBC coating wherein:
a) a bond coat comprising one or more layers is applied to a ceramic matrix composite (CMC) substrate to provide a coated CMC substrate; and
b) a top coat comprising one or more layers is applied to the coated CMC substrate;

wherein at least one sealing layer is applied (i) between the bond coat and the CMC substrate, (ii) between the bond coat and the top coat, (iii) between layers of the bond coat, (iv) between layers of the top coat, and/or (v) on an upper surface of the top coat; and
wherein the at least one sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the at least one sealing layer is applied by atomic layer deposition.

According to further aspect of the present disclosure, there is provided a method for sealing pores of a ceramic matrix composite and/or an environmental barrier coating (EBC) comprising:
applying by atomic layer deposition at least one sealing layer to a surface of the ceramic matrix composite (CMC) substrate or to a surface of a layer of the environmental barrier coating (EBC)
wherein the at least one sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer.

According to another aspect of the present disclosure, there is provided a composite structure comprising:
a) a ceramic matrix composite (CMC) substrate;
b) a bond coat comprising one or more layers above the CMC substrate;
c) a top coat above the bond coat wherein the top coat comprises one or more layers; and
d) at least one sealing layer wherein the sealing layer is applied (i) between the bond coat and the CMC substrate, (ii) between the bond coat and the top coat, (iii) between layers of the bond coat, (iv) between layers of the top coat, and/or (v) on an upper surface of the top coat;
wherein the at least one sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the at least one sealing layer is applied by atomic layer deposition.

In some examples, the at least one sealing layer is applied between the bond coat and the CMC substrate. Additionally or alternatively, in some examples, the at least one sealing layer is applied between the bond coat and the top coat. Additionally or alternatively, in some examples, the bond coat comprises a plurality of layers and the at least one sealing layer is applied between layers of the bond coat. Also, additionally or alternatively, in some examples, the top coat comprises a plurality of layers and the at least one sealing layer is applied between layers of the top coat. Moreover, additionally or alternatively, in some examples, the at least one sealing layer is applied on an upper surface of the top coat.

In some examples, the at least one sealing layer has a thickness of 0.05 to 2 µm. For example, the thickness can be less than 1 µm, or less than 0.2 µm.

In some examples, at least one sealing layer of yttrium oxide (Y₂O₃) is applied by ALD. Additionally or alternatively, at least one sealing layer of lanthanum oxide (La₂O₃) is applied by ALD. Additionally or alternatively, in some examples, at least one sealing layer of ytterbium oxide (Yb₂O₃) is applied by ALD. Additionally or alternatively, in some examples, at least one sealing layer of hafnium oxide (HfO₂) is applied by ALD. Additionally or alternatively, in some examples, at least one sealing layer of zirconium oxide (ZrO₂) is applied by ALD. Additionally or alternatively, in some examples, at least one sealing layer of hafnium silicon oxide (HfSiO₄) is applied by ALD. Additionally or alternatively, in some examples, at least one sealing layer of zirconium silicon oxide (ZrSiO₄) is applied by ALD. Additionally or alternatively, in some examples, at least one sealing layer of ytterbium silicon oxide (Yb₂Si₂O₇) is applied by ALD. Additionally or alternatively, in some examples, at least one sealing layer of aluminum oxide (Al₂O₃) is applied by ALD.

Further, in some examples, the CMC substrate is a SiC/SiC ceramic matrix composite or silicon nitride ceramic matrix composite. Also, in some examples, the bond coat material is a silicon-based material. Additionally, in some examples, the top coat of the EBC comprises oxides selected from ZrO₂, HfO₂, HfSiO₄, RE₂SiO₅, RE₂Si₂O₇, and/or RE₂O₃, where RE is a rare earth metal (i.e., RE is Sc, Y, La, Ce, Pr, Nd, Pm, Sm, Eu, Gd, Tb, Dy, Ho, Er, Tm, Yb, or Lu).

Additionally, in some examples, the layers of the EBC, other than the at least one sealing layer, are applied by atmospheric plasma spray (APS), low pressure plasma spray (LPPS), chemical vapor deposition (CVD), physical vapor Deposition (PVD), electron beam-physical vapor deposition (EB-PVD), or plasma-spray physical vapor deposition (PS-PVD), polymer deposition, or slurry coating.

### Brief Description of the Drawings

Implementations of the inventive concepts disclosed herein may be better understood when consideration is given to the following detailed description thereof. Such description make refers to the included drawings, which are not necessarily to scale, and which some features may be exaggerated and some features may be omitted or may be represented schematically in the interest of clarity. Like reference numerals in the drawings may represent and refer to the same or similar element, feature, or function. **In** the drawings:
Figure 1 illustrates a cross-sectional side view of a CMC substrate with a bond coat and sealing layer on the surface of the CMC substrate between the CMC substrate and the bond coat.
Figure 2 illustrates a cross-sectional side view of a CMC substrate with a bond coat and a top coat with a sealing layer on the surface of the bond coat layer between the bond coat and the top coat.
Figure 3 illustrates a cross-sectional side view of a CMC substrate with a multilayer bond coat and a top coat with a sealing layer positioned between layers of the multilayer bond coat.
Figure 4 illustrates a cross-sectional side view of a CMC substrate with a bond coat and a multilayer top coat with a sealing layer positioned between layers of the multilayer top coat.
Figure 5 illustrates a cross-sectional side view of a CMC substrate with a bond coat and a top coat with a sealing layer applied to the surface of the top coat.

### Detailed Description

Before explaining at least one embodiment of the inventive concepts disclosed herein in detail, it is to be understood that the inventive concepts are not limited in their application to the details of construction and the arrangement of the components or steps or methodologies set forth in the following description or illustrated in the drawings. In the following detailed description of the embodiments of the inventive concepts, numerous specific details are set forth in order to provide a more thorough understanding of the inventive concepts. It will be apparent to one skilled in the art, however, having the benefit of the instant disclosure that the inventive concepts disclosed herein may be practiced without these specific details.

In general, embodiments of the inventive concept include embodiments wherein a CMC substrate is provided with an EBC wherein the composite structure of CMC substrate and EBC is provided with one or more sealing layers applied by atomic layer deposition (ALD). The sealing layers can improve the durability of EBCs by filling pores and/or cracks in the CMC, in the bond coat and/or top layers to inhibit oxidant flow into the EBC and CMC more effectively. Additionally, the sealing layers can provide a seal between layers to inhibit oxidant flow into the EBC and CMC more effectively. The ALD layer can also interact with, for example, the bond coat material to form a more stable composite system.

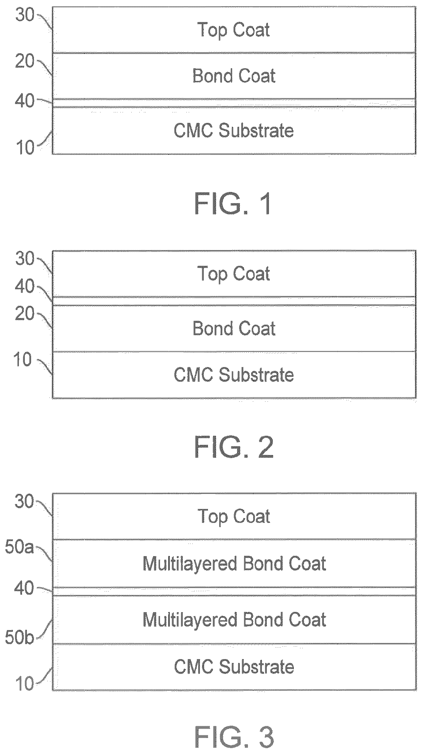

In some embodiments, a sealing layer is applied between the CMC substrate and a bond coat. As shown, for example, in Fig. 1, a composite structure comprises a CMC substrate 10, a bond coat 20, and a top coat 30. The bond coat 20 aids in adhesion between the substrate 10 and the top coat 30. A sealing layer 40 is applied by ALD to the surface of the substrate 10. The sealing layer 40 acts to modify the CMC substrate/bond coat interface providing for the sealing of pores and/or cracks within the substrate 10. Additionally, in some embodiments, the sealing layer 40 can also aid in adhesion of the bond coat 20 to the substrate 10.

The sealing layer is a yttrium oxide, a lanthanum oxide, hafnium oxide, zirconium oxide, hafnium silicon oxide, zirconium silicon oxide, ytterbium oxide, and/or aluminum oxide layer applied by atomic layer deposition (ALD). In some embodiments, the sealing layer is made from only one of these oxides. In other embodiments, the sealing layer includes alternating compositions (e.g., nano-laminates) selected from Y₂O₃, La₂O₃, Yb₂O₃, HfO₂, ZrO₂, HfSiO₄, ZrSiO₄, Yb₂Si₂O₇, and Al₂O₃.

ALD is a deposition technique that allows the application of ultra-thin, conformal, dense films to surfaces. Generally, advantages of ALD include the ability to provide for uniform deposition of layers, the ability to control layer thickness, and the ability to provide for layer deposition on complex three-dimensional surfaces.

In general, in an ALD process, the substrate is paced in a chamber at suitable temperature and pressure, and then precursor materials are sequentially injected into the chamber, with optional purging in between injections. For example, to deposit metal oxide films by an ALD process, two precursors are usually used where on precursor acts as a metal source and the other acts as an oxygen source. The precursors react with the surface to be coated and a thin film is deposited by repeated exposure to the two separate precursors.

Precursors used for ALD of yttrium oxide, lanthanum oxide, ytterbium oxide, hafnium oxide, zirconium oxide, hafnium silicon oxide, zirconium silicon oxide, ytterbium silicon oxide, or aluminum oxide are known within the art. For example, suitable ALD precursors for aluminum oxide layers are trimethylaluminum (TMA) and water, or TMA and ozone. For yttrium oxide layers, suitable ALD precursors include tris(ethylcyclopentadienyl)yttrium and water, or tris(methylcyclopentadienyl)yttrium and water. For hafnium oxide layers, suitable ALD precursors include tetrakis(dimethylamido)hafnium and water. For ALD of zirconium oxide, suitable precursors include water and ZrCl₄, Zr(OEt₂)₄, or Cp₂Zr(CH₃)₂ (where Et = ethyl and Cp = cyclopentadienyl). Lanthanum oxide precursors for ALD include La(thd)₃ (thd is 2,2,6,6-tetramethyl-3,5-heptane-dione), La(Cp)₃ (Cp = cyclopentadienyl), and La(iPrCp)₃ (iPrCp = isopropylcyclopentadienyl) with water or ozone. For ytterbium oxide, suitable ALD precursors include Yb(C₅H₅)₃ and H₂O and/or O₃. Suitable silica precursors for layers containing Si include tetraethoxysilane Si(C₂H₅O)₄, tetraisocyanatosilane, and silicon(IV) chloride with water, and tri-t-butoxysilanol with TMA.

For mixed oxide layers, like hafnium silicon oxide and ytterbium silicon oxide, these can be achieved by using a supercycle approach. The composition can be varied by tuning the cycle ratio and sequence of each process within the supercycle. For example, by regular alternation of binary cycles AOx and BOy, a homogeneous film (ABzOw) can be produced. Alternatively, by repeating each binary cycle multiple times multilayered films of AOx and BOy, also called nanolaminates, can be obtained. Regarding ALD by use of supercycles, see, e.g., M. Coll et al., "Atomic layer deposition of functional multicomponent oxides," APL Materials, vol. 7, issue 11, November 2019.

Additional examples of precursors are described in for example, R. W. Johnson et al., "A brief review of atomic layer deposition: from fundamentals to applications," Materials Today, vol. 17, issue 5, June 2014, pages 236-246.

ALD is performed at lower temperature than CVD (chemical vapor deposition). In general, temperatures for performing ALD reactions are generally <400°C, e.g., <350°C, such as 120°C to 300°C.

Sealing layer thicknesses can vary by varying the number of sequential applications of the precursors to the substrate during the ALD process. In some embodiments, the sealing layer has a thickness of, for example, 0.05 to 2 µm, such as a thickness of less than 1 µm, or less than 0.2 µm, or 0.2 to 1 µm.

The sealing layer can be used with any CMC substrate for which an EBC is provided. In some embodiments, the substrate is a SiC/SiC ceramic matrix composite or silicon nitride ceramic matrix composite. For example, the SiC/SiC ceramic matrix composite can have a SiC matrix that is fabricated by chemical vapor infiltration (CVI). Alternatively, the SiC matrix can be fabricated by infiltration of Si-containing pre-ceramic polymer through the polymer infiltration and pyrolysis (PIP) method. In another case, the SiC matrix can be fabricated my melt infiltration of Si or a Si alloy that reacts with carbon containing material to form SiC. In other embodiments, the matrix can comprise an oxide material.

Aside from the one or more sealing layers, the other layers of the EBC can be applied to the CMC substrate by a variety of processes including atmospheric plasma spray (APS), low pressure plasma spray (LPPS), chemical vapor deposition (CVD), physical vapor Deposition (PVD), electron beam-physical vapor deposition (EB-PVD), or plasma-spray physical vapor deposition (PS-PVD), polymer deposition, and slurry coatings. In some embodiments, the layers of the bond coat and/or top coat are applied by forming a slurry of the coating materials using a solvent or dispersion medium.

The bond coat materials can vary and include, for example, silicon-based materials such as an Si, SiO₂, SiC, Si₃N₄, SiCₓN_{y}, or SiOₓC_{y} particles dispersed in a matrix, and other and Si-based composites, e.g., a SiC/SiO₂/glass oxide composite bond coat. The top coat can comprise a variety of materials including ZrO₂, HfO₂, HfSiO₄, RE₂SiO₅, RE₂Si₂O₇ (e.g., Yb₂Si₂O₇), and RE₂O₃, wherein RE is a rare earth metal.

Referring to the method embodiment of Fig. 1, the method comprises:
a) applying a bond coat comprising one or more layers to a ceramic matrix composite (CMC) substrate to provide a coated CMC substrate;
b) applying a top coat comprising one or more layers to the coated CMC substrate; and
c) applying a sealing layer between the bond coat and the CMC substrate;
wherein the sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), ytterbium silicon oxide (Yb₂Si₂O₇), and/or an aluminum oxide (Al₂O₃) layer, and the sealing layer is applied by atomic layer deposition.

This method embodiment produces a composite structure comprising:
a) a ceramic matrix composite (CMC) substrate;
b) a bond coat comprising one or more layers above the CMC substrate;
c) a top coat above the bond coat wherein the top coat comprises one or more layers; and
d) a sealing layer wherein the sealing layer is applied between the bond coat and the CMC substrate;
wherein the sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the sealing layer is applied by atomic layer deposition.

In the Fig. 1 embodiment, pores of the ceramic matrix composite are sealed by applying by ALD at least one sealing layer to a surface of the ceramic matrix composite (CMC) substrate, i.e., between the CMC and the EBC.

In some embodiments, a sealing layer is applied between the bond coat and a top coat. As shown, for example, in Fig. 2, a composite structure comprises a CMC substrate 10, a bond coat 20, and a top coat 30. A sealing layer 40 is applied by ALD to the surface of the bond coat 20. The sealing layer 40 acts to modify the bond coat/top coat interface providing for the sealing of pores and/or cracks within the bond coat 20. Additionally, in some embodiments, the sealing layer 4 may also aid in adhesion of the top coat 30 to the bond coat 20.

Therefore, referring to Fig. 2, this method embodiment comprises:
a) applying a bond coat comprising one or more layers to a ceramic matrix composite (CMC) substrate to provide a coated CMC substrate; and
b) applying a top coat comprising one or more layers is applied to the coated CMC substrate; and
c) applying a sealing layer between the bond coat and the top coat;
wherein the sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the sealing layer is applied by atomic layer deposition.

This method embodiment produces a composite structure comprising:
a) a ceramic matrix composite (CMC) substrate;
b) a bond coat comprising one or more layers above the CMC substrate;
c) a top coat above the bond coat wherein the top coat comprises one or more layers; and
d) a sealing layer wherein the sealing layer is applied between the bond coat and the top coat;
wherein the sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the sealing layer is applied by atomic layer deposition.

In the Fig. 2 embodiment, pores of the bond coat are sealed by applying by ALD at least one sealing layer to the surface of the bond coat, i.e., between the bond coat and the top coat of the EBC.

In some embodiments, a sealing layer is applied between layers of a multilayer bond coat. As shown, for example, in Fig. 3, a composite structure comprises a CMC substrate 10, a multilayered bond coat 50a and 50b, and a top coat 30. A sealing layer 40 is applied by ALD between layers 50a and 50b of the multilayered bond coat. The sealing layer 40 acts at the interface between layers 50a and 50b of the multilayered bond coat providing for the sealing of pores and/or cracks within the interior of the bond coat. Additionally, in some embodiments, the sealing layer 40 can also aid in adhesion of layers 50a and 50b of the multilayered bond coat.

Therefore, referring to Fig. 3, this method embodiment comprises:
a) applying a bond coat comprising a plurality of layers to a ceramic matrix composite (CMC) substrate to provide a coated CMC substrate; and
b) applying a top coat comprising one or more layers is applied to the coated CMC substrate; and
c) applying a sealing layer between layers of the bond coat;
wherein the sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the sealing layer is applied by atomic layer deposition.

This method embodiment produces a composite structure comprising:
a) a ceramic matrix composite (CMC) substrate;
b) a bond coat comprising a plurality of layers above the CMC substrate;
c) a top coat above the bond coat wherein the top coat comprises one or more layers; and
d) a sealing layer wherein the sealing layer is applied between layers of the bond coat;
wherein the sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the sealing layer is applied by atomic layer deposition.

In the Fig. 3 embodiment, pores of a layer of the bond coat are sealed by applying by ALD at least one sealing layer to the surface of that layer, i.e., between that layer and another layer of the bond coat of the EBC.

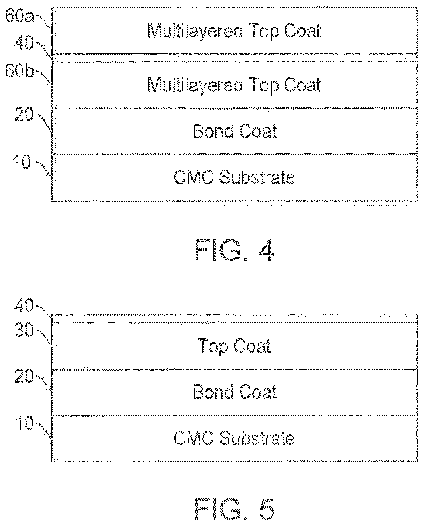

In some embodiments, a sealing layer is applied between layers of a multilayer top coat. As shown, for example, in Fig. 4, a composite structure comprises a CMC substrate 10, a bond coat 20, and a multilayered top coat 60a and 60b. A sealing layer 40 is applied by ALD between layers 60a and 60b of the multilayered top coat. The sealing layer 40 acts at the interface between layers 60a and 60b of the multilayered top coat providing for the sealing of pores and/or cracks within the interior of the top coat. Additionally, in some embodiments, the sealing layer 40 can also aid in adhesion of layers 60a and 60b of the multilayered top coat 6.

Therefore, referring to Fig. 4, this method embodiment comprises:
a) applying a bond coat comprising one or more layers to a ceramic matrix composite (CMC) substrate to provide a coated CMC substrate; and
b) applying a top coat comprising a plurality of layers is applied to the coated CMC substrate; and
c) applying a sealing layer between layers of the top coat;
wherein the sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the sealing layer is applied by atomic layer deposition.

This method embodiment produces a composite structure comprising:
a) a ceramic matrix composite (CMC) substrate;
b) a bond coat comprising one or more layers above the CMC substrate;
c) a top coat above the bond coat wherein the top coat comprises a plurality of layers; and
d) a sealing layer wherein the sealing layer is applied between layers of the top coat;
wherein the sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the sealing layer is applied by atomic layer deposition.

In the Fig. 4 embodiment, pores of a layer of the top coat are sealed by applying by ALD at least one sealing layer to the surface of that layer, i.e., between that layer and another layer of the top coat of the EBC.

In some embodiments, a sealing layer is applied on the upper surface of the top coat. As shown, for example, in Fig. 5, a composite structure comprises a CMC substrate 10, a bond coat 20, and a top coat 03. A sealing layer 40 is applied by ALD on the upper surface of the top coat 30. The sealing layer 40 acts at the surface of the top coat 30 providing for the sealing of pores and/or cracks within on the upper surface of the top coat 30.

Therefore, referring to Fig. 5, this method embodiment comprises:
a) applying a bond coat comprising one or more layers to a ceramic matrix composite (CMC) substrate to provide a coated CMC substrate; and
b) applying a top coat comprising one or more layers is applied to the coated CMC substrate; and
c) applying a sealing layer on an upper surface of the top coat;
wherein the sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the sealing layer is applied by atomic layer deposition.

This method embodiment produces a composite structure comprising:
a) a ceramic matrix composite (CMC) substrate;
b) a bond coat comprising one or more layers above the CMC substrate;
c) a top coat above the bond coat wherein the top coat comprises one or more layers; and
d) a sealing layer wherein the sealing layer is applied on an upper surface of the top coat;
wherein the sealing layer is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the sealing layer is applied by atomic layer deposition.

In the Fig. 5 embodiment, pores of top surface of the top coat of the EBC are sealed by applying by ALD at least one sealing layer to the top surface.

By way of an exemplary embodiment, a composite in accordance with the present disclosure can be, for example, a CMC substrate proved with a multi-layer EBC comprising an HfSiO₄ top coat layer and a bond coat layer, wherein the bond coat is a SiO₂-based and comprises a silicate glass with additives such as Al, Mg, Ba, Ca, B, and/or Na. The bond coat is deposited, for example, by slurry processing resulting in pores being present within the coating. Pores and cracks present within the bond coat are sealed/filled with Y₂O₃, La₂O₃, Yb₂O₃, HfO₂, ZrO₂, HfSiO₄, ZrSiO₄, Yb₂Si₂O₇, and/or Al₂O₃ using ALD, wherein the ALD deposition forms, for example, a 0.2 to 1micron thick layer.

By way of a further exemplary embodiment, a composite in accordance with the present disclosure can be, for example, a CMC substrate proved with a multi-layer EBC comprising a Yb₂Si₂O₇ top coat layer and a bond coat layer, wherein the bond coat is SiO₂-based and comprises a silicate glass with additives such as Al, Mg, Ba, Ca, B, and/or Na. The bond coat is deposited, for example, by slurry processing resulting in pores being present within the coating. Pores and cracks present within the bond coat are sealed/filled with Y₂O₃, La₂O₃, Yb₂O₃, HfO₂, ZrO₂, HfSiO₄, ZrSiO₄, Yb₂Si₂O₇, and/or Al₂O₃ using ALD, wherein the ALD deposition forms, for example, a 0.2 to 1micron thick layer.

By way of a further exemplary embodiment, a composite in accordance with the present disclosure can be, for example, a CMC substrate proved with a multi-layer EBC comprising an HfSiO₄ top coat and a bond coat, wherein the bond coat is a SiO₂-based and comprises a silicate glass with additives such as Al, Mg, Ba, Ca, B, and/or Na. Interfaces within the EBC (e.g., interfaces between layers of the bond coat, interfaces between layers of the top coat, and/or the interface between the bond coat and the top coat) are coated with a sealing layer to seal pores/cracks at the interfaces and promote adhesion between the layers. The sealing layer comprises Y₂O₃, La₂O₃, Yb₂O₃, HfO₂, ZrO₂, HfSiO₄, ZrSiO₄, Yb₂Si₂O₇, and/or Al₂O₃ and is applied using ALD, wherein the ALD deposition forms, for example, a 0.2 to 1micron thick layer.

The corresponding structures, material, acts, and equivalents of all means or steps plus function elements in the claims below are intended to include any structure, material, or act for performing the function in combination with other claimed elements are specifically claimed. The description of the present invention has been presented for purposes of illustration and description, but is not intended to be exhaustive or limited to the invention in the form disclosed. Many modifications and variations will be apparent to those of ordinary skill without departing from the scope and spirit of the invention. The embodiment was chosen and described in order to best explain the principles of the invention and the practical application, and to enable others of ordinary skill in the art to understand the invention for embodiments with various modifications as are suited to the particular use contemplated.

Modifications and equivalents may be made to the features of the claims without departing from the spirit or scope of the invention. Thus, it is intended that the present invention covers the modifications and variations disclosed above provided that these changes come within the scope of the claims and their equivalents.

## Claims

1. A method for sealing pores of a ceramic matrix composite and/or an environmental barrier coating (EBC) comprising:
applying by atomic layer deposition at least one sealing layer (40) to a surface of the ceramic matrix composite (CMC) substrate (10) or to a surface of a layer (20; 30; 50b; 60b) of the environmental barrier coating (EBC),
wherein the at least one sealing layer (40) is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer.

2. The method according claim 1, wherein the at least one sealing layer (40) has a thickness of 0.05 to 2 µm.

3. A method for preparing an environmental barrier coating (EBC) coating, said method comprising:
a) applying a bond coat (20; 50a, 50b) comprising one or more layers (20; 50a, 50b) to a ceramic matrix composite (CMC) substrate (10) to provide a coated CMC substrate; and
b) applying a top coat (30; 60a, 60b) comprising one or more layers (30; 60a, 60b) to the coated CMC substrate; and
applying, by the method of claim 1 or 2, at least one sealing layer (40): (i) between the bond coat (20) and the CMC substrate (10); (ii) between the bond coat (20) and the top coat (30); (iii) between layers (50a, 50b) of the bond coat (50a, 50b); (iv) between layers (60a, 60b) of the top coat (60a, 60b); and/or (v) on an upper surface of the top coat (30).

4. The method according claim 3, wherein the at least one sealing layer (40) is applied between the bond coat (20) and the CMC substrate (10).

5. The method according to claim 3, wherein the at least one sealing layer (40) is applied between the bond coat (20) and the top coat (30).

6. The method according to claim 3, wherein the bond coat (50a, 50b) comprises a plurality of layers (50a, 50b) and the at least one sealing layer (40) is applied between layers (50a, 50b) of the bond coat (50a, 50b).

7. The method according to claim 3, wherein the top coat (60a, 60b) comprises a plurality of layers (60a, 60b) and the at least one sealing layer (40) is applied between layers (60a, 60b) of the top coat (60a, 60b).

8. The method according to claim 3, wherein the at least one sealing layer (40) is applied on an upper surface of the top coat (30).

9. The method according to any preceding claim, wherein:
the at least one sealing layer (40) comprises yttrium oxide (Y₂O₃) which is produced by ALD using tris(ethylcyclopentadienyl)yttrium and water or tris(methylcyclopentadienyl)yttrium and water as ALD precursors; or
the at least one sealing layer (40) comprises lanthanum oxide (La₂O₃) which is produced by ALD using La(2,2,6,6-tetramethyl-3,5-heptane-dione)₃, La( cyclopentadienyl)₃ or La(isopropylcyclopentadieny)₃ with water or ozone as ALD precursors.

10. The method according to any of claims 1 to 8, wherein:
the at least one sealing layer (40) comprises hafnium oxide (HfO₂) which is produced by ALD using tetrakis(dimethylamido)hafnium and water as ALD precursors; or
the at least one sealing layer (40) comprises zirconium oxide (ZrO₂) which is produced by ALD using ZrCl₄, Zr(OEt₂)₄, or Cp₂Zr(CH₃)₂ and water as ALD precursors, where Et is ethyl and Cp is cyclopentadienyl, as ALD precursors.

11. The method according to any of claims 1 to 8, wherein:
the at least one sealing layer (40) comprises hafnium ytterbium oxide (Yb₂O₃) which is produced by ALD using precursors include Yb(C₅H₅)₃ and H₂O and/or O₃ as ALD precursors; or
the at least one sealing layer (40) comprises aluminum oxide (Al₂O₃) which is produced by ALD using trimethylaluminum (TMA) and water or ozone as ALD precursors.

12. The method according to any preceding claim, wherein the CMC substrate (10) is a SiC/SiC ceramic matrix composite or silicon nitride ceramic matrix composite, the bond coat material is a silicon-based material, and the top coat (30; 60a, 60b) comprises oxides selected from ZrO₂, HfO₂, HfSiO₄, RE₂SiO₅, RE₂Si₂O₇, and/or RE₂O₃, wherein RE is a rare earth metal.

13. The method according to any preceding claim, wherein the layers (20; 30; 50a, 50b; 60a, 60b) of the EBC, other than the at least one sealing layer (40), are applied by atmospheric plasma spray (APS), low pressure plasma spray (LPPS), chemical vapor deposition (CVD), physical vapor Deposition (PVD), electron beam-physical vapor deposition (EB-PVD), or plasma-spray physical vapor deposition (PS-PVD), polymer deposition, or slurry coating.

14. A composite structure comprising:
a) a ceramic matrix composite (CMC) substrate (10);
b) a bond coat (20; 50a, 50b) comprising one or more layers (20; 50a, 50b) above the CMC substrate (10);
c) a top coat (30; 60a, 60b) above the bond coat (20; 50a, 50b) wherein the top coat (30; 60a, 60b) comprises one or more layers (30; 60a, 60b); and
d) at least one sealing layer (40) wherein the sealing layer (40) is applied (i) between the bond coat (20) and the CMC substrate (10), (ii) between the bond coat (20) and the top coat (30), (iii) between layers (50a, 50b) of the bond coat (50a, 50b), (iv) between layers (60a, 60b) of the top coat (60a, 60b), and/or (v) on top of the top coat (30);
wherein the at least one sealing layer (40) is a yttrium oxide (Y₂O₃), a lanthanum oxide (La₂O₃), a ytterbium oxide (Yb₂O₃), a hafnium oxide (HfO₂), a zirconium oxide (ZrO₂), a hafnium silicon oxide (HfSiO₄), a zirconium silicon oxide (ZrSiO₄), a ytterbium silicon oxide (Yb₂Si₂O₇), and/or an aluminum oxide (Al₂O₃) layer, and the at least one sealing layer (40) is applied by atomic layer deposition.

15. The composite according claim 14 or method according to any of claims 1 to 13, wherein the at least one sealing layer (40) has a thickness of 0.05 to 2 µm, optionally of 0.2 to 1 µm.
